# EUROPÄISCHE PATENTSCHRIFT

(11) **EP 0 501 192 B1**
(45) Veröffentlichungstag und Bekanntmachung des Hinweises auf die Patenterteilung: **24.04.1996**
(21) Anmeldenummer: 92101900.6
(22) Anmeldetag: 05.02.1992
(51) Int. Cl.: H05K 5/00

(54) **Elektronisches Steuergerät**
Electronic controlling device
Appareil de commande électronique

(30) Priorität: 28.02.1991 DE 4106453
(43) Veröffentlichungstag der Anmeldung: 02.09.1992
(73) Patentinhaber: SIEMENS AKTIENGESELLSCHAFT, D-80333 München (DE)
(72) Erfinder: Kaiser, Werner, Dipl.-Ing, W-8402 Neutraubling (DE)

(56) Entgegenhaltungen:
- EP-A- 0 353 443
- DE-A- 3 437 988
- DE-A- 3 502 584
- DE-U- 8 906 726
- US-A- 4 388 672

## Beschreibung

Die Erfindung betrifft ein elektronisches Steuergerät gemäß Oberbegriff von Anspruch 1.

Bei einem solchen, aus EP 0 353 443 bekannten Steuergerät gehört zu jeder Leiterplatte ein eigener Tragrahmen mit je zwei Aussparungen, die den beiden Steckern zugeordnet sind.

Aus der DE 34 37 988 A1 ist ferner ein Steuergerät mit zwei durch eine flexible Leitung verbundenen Leiterplatten bekannt; letztere sind an einem zweiteiligen Stecker befestigt.

Die Erfindung gemäß Anspruch 1 zeichnet sich dem gegenüber insbesondere dadurch aus, daß eine - als Kühlkörper wirksame - Seitenwand des Gehäuses Teil eines Rahmens ist, auf dessen Außenseiten die Leiterplatten befestigt sind. Dieses Konzept ermöglicht es, eine der Leiterplatten mit dem Rahmen zu verbinden und dann beide Leiterplatten nach Bestückung mit Bauteilen gleichzeitig zu Löten, zu Lackieren oder zu Prüfen. Lötstellen zwischen den Anschlüssen von Leistungsbauelementen an der Seitenwand des Rahmens und der erstgenannten Leiterplatte werden somit nach dem Löten nicht mehr durch Montagearbeiten belastet.

Die Erfindung wird anhand eines Ausführungsbeispieles näher erläutert. Es zeigen:
- Figur 1: ein elektronisches Steuergerät nach der Erfindung in einer auseinandergezogenen Perspektivdarstellung,
- Figur 2: das Steuergerät nach Figur 1 in der Vorderansicht in größerem Maßstab,
- Figur 3: das Steuergerät nach Figur 1 und 2 in einer geschnittenen Seitenansicht,
- Figur 4: das Steuergerät nach Figur 2 in einer teilweise geschnittenen Draufsicht.

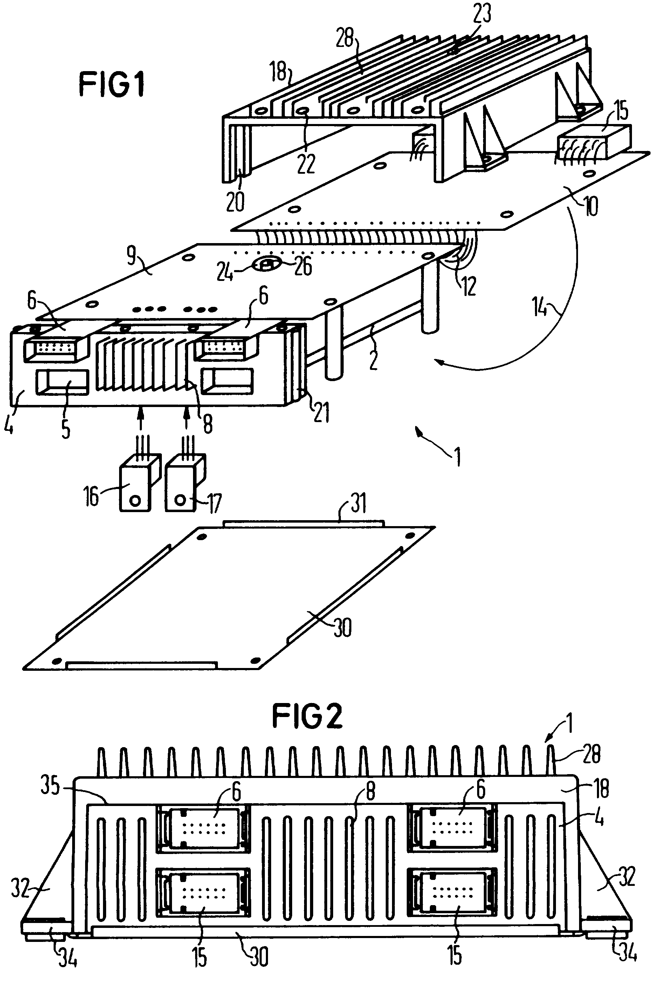

Ein elektronisches Steuergerät 1 (Figur 1) wird in dem vorliegenden Beispiel zum Steuern einer Hinterachslenkung nach dem Prinzip der aktiven Hinterachs-Kinematik eingesetzt. Es weist einen Tragrahmen 2 auf, der als etwa quaderförmiger, flacher Gitter- oder Stabrahmen ausgebildet ist und an seiner - in der Zeichnung vorn liegenden - Schmalseite eine flächige Außenwand 4 aufweist. Die Außenwand 4 ist mit vier Öffnungen 5 versehen, durch die Steckerteile 6 von innen hindurchgesteckt und mit seitlichen Rastelementen eingeschnappt und damit befestigt sind. In Figur 1 sind nur zwei Steckerteile 6 dargestellt. Die Außenwand 4 ist mit Kühlelementen in Form von die Oberfläche vergrößernden Kühlrippen 8 versehen. Zweckmäßigerweise ist der ganze Tragrahmen 2 als Spritzgußteil aus Leichtmetall ausgebildet.

Als Schaltungsträger des Steuergeräts 1 dienen zwei Leiterplatten 9 und 10, die jeweils mit zwei der Steckerteilen 6 mechanisch verbunden sind. An der Leiterplatte 9 werden die beiden Steckerteile 6 festgenietet oder -geschraubt und dann in die entsprechenden Aussparungen 5 in der Außenwand 4 von hinten soweit eingeschoben, bis sie einrasten. Sie dienen dann als Führung zum Verschrauben der Leiterplatte 9 mit dem Tragrahmen 2. Die Leiterplatte 9 wird mit dem Tragrahmen 2 in der Stellung verschraubt, in der sie in Figur 1 dargestellt ist.

Die beiden Leiterplatten 9 und 10 sind durch ein nachgiebiges Flachbandkabel 12 elektrisch miteinander verbunden. Sie liegen in Figur 1 beide noch in einer Ebene, in der sie mit Bauteilen bestückt und in einem Lötbad verlötet werden. Anschließend werden sie geprüft und gegebenenfalls auch in einem Tauchbad lackiert. Sie stehen dabei etwas über den Tragrahmen nach hinten über und können deshalb soweit in das Lackierbad eingetaucht werden, daß sie vollständig von dem Lack bedeckt werden, die Lackiergrenze aber den Tragrahmen 2 und insbesondere die Außenwand 4 nicht erreicht. Das Gehäuse-Äußere zeigt somit keine Lackspuren, ohne daß es dazu bei der Herstellung abgedeckt werden müßte.

Nach dem Fertigstellen der Leiterplatten 9, 10 wird die Leiterplatte 10 herumgeklappt - wie durch einen Pfeil 14 angedeutet - und an dem Tragrahmen 2 von unten festgeschraubt. Das Flachbandkabel 12 ermöglicht dieses Umklappen ohne weiteres, die Lötstellen auf den Leiterplatten werden dabei nicht mechanisch belastet. Auf der Leiterplatte 10 sind zwei Steckerteile 15 befestigt. Zwei Leistungsbauelemente 16 und 17 werden vor dem Löten mit einer elektrisch isolierenden Zwischenschicht an der Innenseite der Außenwand 4 des Tragrahmens 2 so befestigt, z.B. geklebt, daß ein guter Wärmeübergang stattfindet. Da die Außenseite der Außenwand 4 mit den Kühlrippen 8 versehen ist, kann mit dieser Anordnung ein Wärmegangsüberstand von 1K/W zwischen der Grundplatte eines Leistungstransistors und der Außenluft realisiert werden.

Ein auf vier Seiten geschlossenes Gehäuseoberteil 18 weist an seinen vorderen Rändern zwei halbringförmige Nuten 20 auf, die als Führung dienen, um das Gehäuseoberteil 18 - nachdem auch die Leiterplatte 10 an dem Tragrahmen befestigt ist - auf den Tragrahmen 2 aufzuschieben. Die Außenwand 4 weist seitlich zwei halbrundförmige Stege 21 auf, die dabei in die Nuten 20 eingeschoben werden. Anschließend wird das Gehäuseoberteil 18 mit vier Schrauben, die durch Öffnungen 22 hindurchgesteckt werden, mit dem Tragrahmen 2 verschraubt. Durch eine Öffnung 23 in dem Gehäuseoberteil 18 und eine Aussparung 24 in der Leiterplatte 9 wird eine weitere Schraube hindurchgesteckt, die das Gehäuseoberteil 23 mit einem hinteren Steg 26 des Tragrahmens 2 verbindet und dadurch mechanische Schwingungen in dem Steuergerät 1 verhindert.

Das Gehäuseoberteil 18 ist mit weiteren Kühlelementen in Form von Kühlrippen 28 versehen. Da es durch die erwähnte Verschraubung innig mit dem Tragrahmen 2 verbunden ist, dient es als wirksamer Zusatzkühlkörper. Ein Blechdeckel 30 schließt das Steuergerät 1 nach unten ab. Er wird mit zwei Schrauben hinten an dem Gehäuseoberteil 18 und mit zwei Schrauben vorne an dem Tragrahmen 2, und zwar in dem Bereich der Stege 21, von unten festgeschraubt. Er ist an seinen Seitenkanten mit Umbördelungen 31 versehen, die um die Kanten der Außenwand 4 und des Gehäuseoberteils 18 herumgreifen und das Gehäuse abdichten. Das Steuergerät 1 ist somit durch das Gehäuse, das aus dem Gehäuseoberteil 18, der Tragrahmen-Außenwand 4 und dem Blechdeckel 30 besteht, mechanisch geschützt und gegen elektromagnetische Ein- und Ausstrahlungen abgeschirmt.

In den Figuren 2 bis 4 haben die Teile, die schon anhand der schematischeren Figur 1 beschrieben worden sind, die gleichen Bezugszeichen erhalten. Sie werden nicht erneut erwähnt. Das Gehäuseoberteil 18 ist mit insgesamt vier angegossenen Flanschen 32 versehen, die je eine Öffnung oder Bohrung 34 aufweisen, durch die Schrauben hindurchgesteckt werden, mit denen das Steuergerät 1 in einem Kraftfahrzeug befestigt wird. Mit einer Linie 35 ist die Grenzfläche für den Wärmeübergang zwischen der Außenwand 4 des Tragrahmens und dem Gehäuseoberteil 18 dargestellt. Das Steuergerät 1 ist hier vollständig montiert, so daß auch die auf der Leiterplatte 10 befestigten Steckerteile 15 durch die entsprechenden Öffnungen der Außenwand 4 hindurchgesteckt sind (Figur 2).

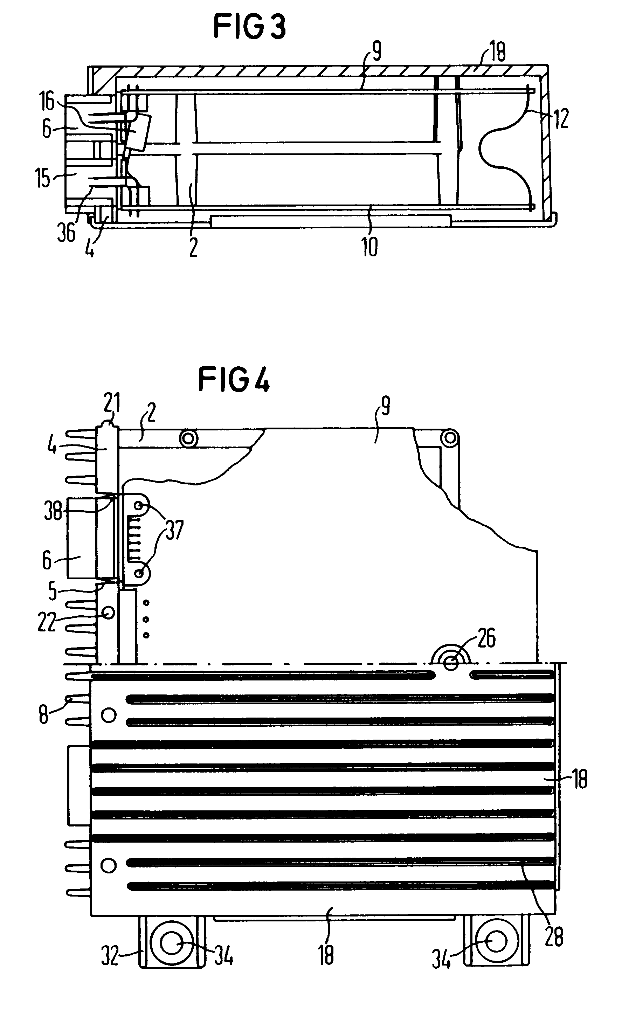

Jedes Steckerteil 6, 15 enthält mehrere paarweise angeordnete Steckerstifte oder -messer 36 (Figur 3).

In der oberen Hälfte von Figur 4 ist das Gehäuseoberteil 18 weggelassen. Dadurch ist erkennbar, daß die Steckerteile 6 - wie auch die Steckerteile 15 - durch Nieten 37 mit der Leiterplatte 9 bzw. 10 mechanisch verbunden sind. Außerdem weisen die Steckerteile, wie bereits angedeutet, seitlich federnde Rasthaken 38 auf, die, sobald das Steckerteil ganz in die Außenwand 4 eingeschoben worden ist, hinter einem Vorsprung am Rand der Aussparung 5 einrasten und dabei das Steckerteil 6, 15 und damit die Leiterplatte 9, 10 in ihrer endgültigen Stellung festhalten.

## Patentansprüche

1. Elektronisches Steuergerät mit einem Gehäuse und zwei Leiterplatten (9,10), die über ein flexibles Flachbandkabel (12) elektrisch miteinander und mit je zwei Steckern (6, 15) mechanisch verbunden sind, die Aussparungen (5) in einer Seitenwand (4) des Gehäuses zugeordnet sind,
**dadurch gekennzeichnet**,
daß die Seitenwand (4) Teil eines Tragrahmens (2) ist, auf dessen Außenseiten die Leiterplatten befestigt sind, wobei die Stekker (6, 15) in die Aussparungen (5) eingerastet sind und die mit dem Flachbandkabel (12) verbundenen Enden der Leiterplatten den Tragrahmen überragen.

2. Steuergerät nach Anspruch 1, dadurch gekennzeichnet, daß die Steckerteile als Führungselement zum Verschrauben der Leiterplatten (9, 10) mit dem Tragrahmen (2) ausgebildet sind.

3. Steuergerät nach Anspruch 1, dadurch gekennzeichnet, daß ein Gehäuseoberteil (18) mit Führungsnuten zum Einschieben des Tragrahmens (2) versehen ist.

4. Steuergerät nach Anspruch 1, dadurch gekennzeichnet, daß die Seitenwand (4) des Tragrahmens (2) mit Kühlrippen (8) versehen ist.

5. Steuergerät nach Anspruch 1, dadurch gekennzeichnet, daß das Gehäuseoberteil (18) mit Kühlrippen (28) versehen ist.

6. Steuergerät nach Anspruch 1, dadurch gekennzeichnet, daß elektronische Leistungsbauteile (16, 17) mit einer elektrisch isolierenden Zwischenschicht an der Innenseite der Seitenwand (4) des Tragrahmens befestigt sind.

## Claims

1. Electronic control unit having a housing and two printed circuit boards (9, 10), which are electrically connected to one another via a flexible ribbon cable (12) and are mechanically connected to in each case two plugs (6, 15) which are assigned to recesses (5) in a side wall (4) of the housing, characterized in that the side wall (4) is part of a supporting frame (2), on the outer sides of which the printed circuit boards are fixed, the plugs (6, 15) being latched into place in the recesses (5), and those ends of the printed circuit boards which are connected to the ribbon cable (12) projecting over the supporting frame.

2. Control unit according to Claim 1, characterized in that the plug parts are designed as a guiding element for screwing the printed circuit boards (9, 10) to the supporting frame (2).

3. Control unit according to Claim 1, characterized in that a top part (18) of the housing is provided with guiding grooves for pushing in the supporting frame (2).

4. Control unit according to Claim 1, characterized in that the side wall (4) of the supporting frame (2) is provided with cooling ribs (8).

5. Control unit according to Claim 1, characterized in that the top part (18) of the housing is provided with cooling ribs (28).

6. Control unit according to Claim 1, characterized in that electronic power components (16, 17) are fixed with an electrically insulating interlayer to the inside of the side wall of the supporting frame.

## Revendications

1. Dispositif de commande électronique comportant un boîtier et deux plaquettes à circuits imprimés (9,10), qui sont reliées électriquement entre elles par l'intermédiaire d'un câble en forme de ruban plat flexible (12), et liées chacune mécaniquement à deux connecteurs (6,15) qui sont associés à des ouvertures (5) ménagées dans une paroi latérale (4) du boîtier,
caractérisé en ce que la paroi latérale (4) fait partie d'un châssis de support (2), sur les faces extérieures duquel sont fixées les plaquettes à circuits imprimés, les connecteurs (6,15) étant encliquetés dans les ouvertures (5), tandis que les extrémités, qui sont reliées au câble en forme de ruban plat (12), des plaquettes à circuits imprimés font saillie au-delà du châssis de support.

2. Dispositif de commande selon la revendication 1, caractérisé en ce que les connecteurs sont constitués comme des éléments de guidage pour le vissage des plaquettes à circuits imprimés (9,10) au châssis de support (2).

3. Dispositif de commande selon la revendication 1, caractérisé en ce qu'une partie supérieure (18) du boîtier comporte des rainures de guidage pour l'insertion du châssis de support (2).

4. Dispositif de commande suivant la revendication 1, caractérisé en ce que la paroi latérale (4) du châssis de support (2) comporte des ailettes de refroidissement (8).

5. Dispositif de commande selon la revendication 1, caractérisé en ce que la partie supérieure (18) du boîtier porte des ailettes de refroidissement (28).

6. Dispositif de commande selon la revendication 1, caractérisé en ce que des composants électroniques de puissance (16,17) sont fixés, au moyen d'une couche intercalaire électriquement isolante, à la face intérieure de la paroi latérale (4) du châssis de support.
